# FASCICULE DE BREVET EUROPEEN

(11) **EP 1 734 568 B1**
(45) Date de publication et mention de la délivrance du brevet: **14.10.2015**
(21) Numéro de dépôt: 06115549.5
(22) Date de dépôt: 15.06.2006
(51) Int. Cl.: H01L 21/336, H01L 29/10, H01L 29/786

(54) **Transistor isolé à canal contraint et son procédé de fabrication**
Isolierter Transistor mit einem verspannten Kanal und Herstellungsverfahren
Insulated transistor having a strained channel and method of manufacturing the same

(30) Priorité: 17.06.2005 FR 0551664
(43) Date de publication de la demande: 20.12.2006
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: Barbe, Jean-Charles, 38000 Grenoble (FR); Barraud, Sylvain, 38690 Le Grand Lemps (FR); Fenouillet-Beranger, Claire, 38000 Grenoble (FR); Gallon, Claire, 38100 Grenoble (FR); Halimaoui, Aomar, 38660 La Terrasse (FR)
(74) Mandataire: Ahner, Philippe

(56) Documents cités:
- EP-A- 1 178 532
- EP-A- 1 487 007
- WO-A-2004/073043
- WO-A1-2005/017992
- US-A- 4 104 090
- US-A- 5 637 515
- US-A1- 2004 031 979
- US-A1- 2004 217 430
- US-A1- 2005 090 066
- US-B1- 6 717 216

## Description

L'invention concerne le domaine de l'industrie du semi-conducteur et plus spécifiquement l'industrie microélectronique.

Les circuits intégrés sont habituellement construits sur des substrats en silicium. Ces substrats peuvent être constitués, en surface, d'une ou de plusieurs couches de nature différentes, l'une d'entre elle pouvant être électriquement isolante. Les substrats de type « silicium sur isolant » aussi appelé substrats « SOI » acronyme de la dénomination anglaise « Silicon On Insulator » sont ainsi couramment utilisés dans l'industrie microélectronique, entre autre pour la fabrication des transistors, car ils permettent une réduction des capacités parasites et une diminution des courants de fuite en volume améliorant ainsi les caractéristiques électriques des composants.

Une contrainte ou une déformation (contraintes et déformations étant reliées par une loi linéaire pour un matériau dit élastique, on utilise dans la suite indifféremment l'un de ces deux termes) appliquée à un matériau semi-conducteur induit une modification de la maille cristalline et donc de la structure de bande, dont va découler une modification de la mobilité des porteurs : la mobilité des électrons est augmentée (respectivement diminuée) par une sollicitation en tension (respectivement en compression) du silicium dans lequel ils transitent alors que la mobilité des trous sera augmentée (resp. diminuée) lorsque le semi-conducteur est comprimé (resp. étiré).

Depuis une dizaine d'année, l'industrie microélectronique met en oeuvre ce principe pour améliorer les caractéristiques électriques des dispositifs de type transistor MOS.

Le document WO 2005/017992 divulgue un transistor MOS avec canal, source et drain disposés sur une couche isolante.

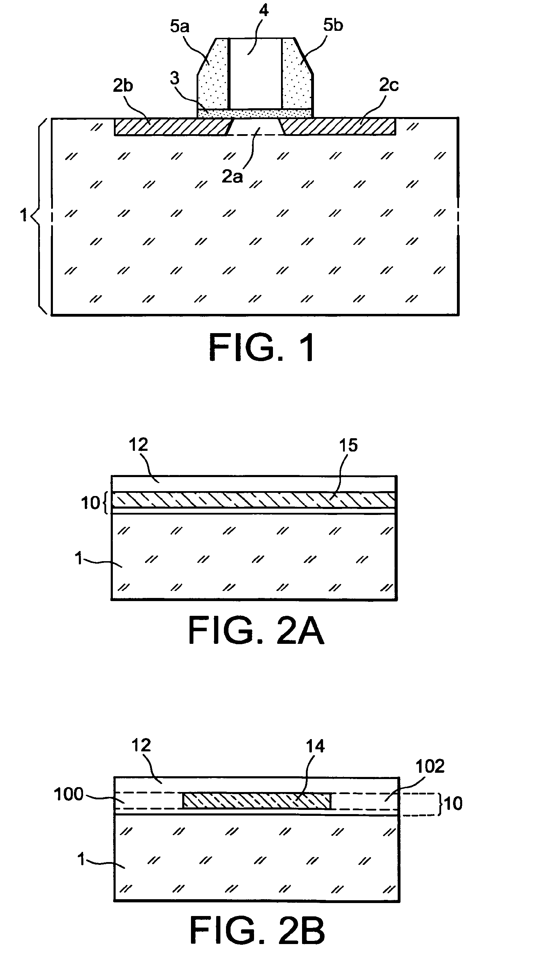

Comme illustré sur la figure 1, un transistor MOS, construit à la surface d'un substrat 1 comprend les éléments fonctionnels suivant : une grille 4, de quelques dizaines de nanomètres de large (et par exemple, d'une centaine de nanomètres de hauteur) séparée du canal (zone dite « de transport » 2a sur la figure 1) par un isolant électrique dit isolant de grille (zone 3 sur la figure 1).

De part et d'autre du canal, se trouvent les zones dite « d'accès » à la zone de transport, aussi appelées source et drain (zones 2b et 2c, hachurées sur la figure 1).

Source, canal et drain sont typiquement formées dans un matériau semi-conducteur, le plus souvent du silicium.

Les sources et drain sont classiquement définies dans le silicium par implantation ionique dans celui-ci : le canal 2a n'est ici qu'une région du silicium initial dopée différemment des régions source 2b et drain 2c. La nature de l'espèce ionique implantée (donneur ou accepteur d'électrons) définit la nature du transistor formé (respectivement NMOS ou PMOS) et la sollicitation mécanique à laquelle le canal devra être soumise pour améliorer ses performances.

Un transistor de type NMOS (resp. PMOS) verra donc ses caractéristiques électriques améliorées par une sollicitation en tension (resp. en compression) de la zone de transport.

De part et d'autre de la grille 4, et au dessus du canal 2a, de la source 2b et du drain 2c on peut trouver des espaceurs (référencés 5a et 5b sur la figure 1) qui peuvent être constitués de deux couches : la première couche, au contact de la grille, peut être constituée de dioxyde de silicium amorphe alors que la seconde est souvent formée de nitrure de silicium (Si3N4). Sur la figure 1 cet ensemble espaceur est schématisé en un seul bloc (5a et 5b).

L'intégration dans les zones dites source 2b et drain 2c, par hétéro-épitaxie, d'un matériau semi-conducteur (par ex. un alliage SiGe) ayant un paramètre de maille différent de celui du matériau constituant le canal 2a (Si), permet de contraindre le canal 2a comme indiqué dans le document US 2003/0080361 A1.

La technique décrite dans ce document permet d'améliorer les caractéristiques électriques d'un transistor PMOS. Toutefois, elle suppose que, sous la source, le drain et le canal, le silicium soit à nu pour permettre la reprise d'épitaxie SiGe.

Cette solution ne permet donc pas d'isoler le composant car les couches d'isolation (SiO₂) sont principalement amorphes et ne permettent donc pas d'effectuer une reprise d'épitaxie à leur surface.

Par une telle technique, il est donc difficile de limiter les courants de fuite ou de supprimer les capacités parasites par une couche qui isolerait électriquement le composant du substrat silicium sur lequel il est bâti.

Une solution à ce problème est proposée dans le brevet français n° FR-02-04165, par la formation d'un tunnel isolant sous le canal et sous les zones de jonction entre source et canal d'une part et entre canal et drain d'autre part. Cette invention met aussi en oeuvre un canal contraint, mais ce dernier est contraint intrinsèquement en tension : cette configuration améliore les caractéristiques électriques d'un transistor NMOS mais détériore les caractéristiques des composants PMOS. De plus, la solution proposée ne permet pas de former une couche isolante continue sous l'ensemble du dispositif.

Il se pose donc le problème de trouver un procédé et un dispositif dont les performances sont améliorées par rapport aux structures connues.

### EXPOSÉ DE L'INVENTION

L'invention concerne d'abord un dispositif semi-conducteur de type transistor selon la revendication 1.

La couche isolante, qui isole le canal du substrat, peut être obtenue par oxydation d'un matériau poreux, lui-même résultant d'une transformation du même matériau dense.

La couche isolante peut résulter de l'oxydation d'un alliage de Si et de Ge préalablement rendu poreux, les zones de source et de drain pouvant alors être en Silicium.

La couche isolante peut résulter de l'oxydation d'un alliage SiₓGe₁₋ₓ (0<x<1), les zones de source et de drain pouvant alors être en Si_{y}Ge_{1-y} (0<y<1) .

La couche isolante peut être continue et s'étendre sur la totalité de la surface du substrat, son épaisseur pouvant varier d'une zone à une autre du substrat ; les zones de drain et de source étant formées dans des cavités qui, au final, ne débouchent pas dans le substrat mais s'arrêtent à la surface ou dans l'épaisseur de la couche isolante.

Les zones de source et de drain peuvent être obtenues par épitaxie. Cette épitaxie, lorsqu'elle est mise en oeuvre à partir du matériau poreux, obstrue les pores débouchant en surface de ladite couche poreuse sans les remplir.

La couche isolante peut être discontinue, les zones de drain et de source étant formées dans des cavités débouchant dans le substrat.

La couche isolante peut être discontinue, les zones de drain et de source étant formées dans des cavités débouchant dans la couche isolante.

Des zones peuvent être maintenues denses (et donc non isolantes) entre la source et/ou le drain et les parois latérales isolantes, pour amplifier les contraintes appliquées par la source et le drain sur le canal.

Afin d'obtenir la contrainte souhaitée, le matériau constitutif des zones de drain et de source peut être de paramètre de maille et/ou de coefficient de dilatation thermique différent du paramètre de maille et/ou du coefficient de dilatation thermique du matériau de la couche qui sera ultérieurement oxydée pour former la couche isolante, si au final ces zones débouchent en surface ou dans l'épaisseur de la couche isolante, ou du paramètre de maille et/ou du coefficient de dilatation thermique du substrat, si ces zones sont formées sur le substrat.

Le canal peut donc être en compression ou en tension.

Un transistor selon l'invention peut être de type NMOS ou PMOS.

En ce qui concerne l'isolant de grille, celui-ci peut être en HfO₂.

La grille peut quant à elle comporter un empilement de TiN et d'une couche en silicium poly-cristallin.

Les espaceurs peuvent être en Si₃N₄ ou comporter un empilement de SiO₂ et de SiN.

La zone de canal peut être implantée N+.

L'invention propose également un procédé de fabrication d'un transistor selon la revendication 12.

Un tel procédé permet d'obtenir une déformation du canal tout en offrant la possibilité d'avoir une couche électriquement isolante, continue ou non, sous l'ensemble du dispositif.

L'invention concerne donc également un procédé permettant d'obtenir un composant de type transistor, par exemple de type MOS, à canal contraint et isolé par rapport au substrat et aux composant qui l'entourent.

Un effet de sollicitation mécanique permet de modifier les caractéristiques du transport électronique, ce qui permet d'obtenir des caractéristiques électriques améliorées par rapport à celle d'un dispositif non contraint.

De plus, le composant contraint, ou au moins le canal du composant, est isolé électriquement par rapport au substrat sur lequel il est fabriqué ; cette isolation pouvant s'étendre sous toute ou partie du composant.

Cette préparation d'un empilement technologique spécifique peut être réalisée à partir d'un substrat de silicium (éventuellement dopé).

Selon l'invention, il y a formation d'une couche ou d'une zone enterrée dopée et délimitée de son environnement par une zone de silicium faiblement dopée N (concentration inférieure à 10¹⁷atomes/cm³).

Une telle architecture de départ permet ensuite de mettre en oeuvre une étape électrochimique permettant de rendre poreuse une zone enterrée du substrat. Cette étape électrochimique n'est sélective que par rapport aux zones N faiblement dopées (concentration inférieure à 10¹⁷atomes/cm³) : l'empilement technologique construit conduit donc à la formation de zones N faiblement dopées qui délimitent des zones dopées P ou N+: ces zones N servent de zones d'arrêt à la transformation électrochimique.

La formation de la couche isolante poreuse peut comporter une étape d'oxydation d'une couche poreuse.

On peut donc :
- former la première couche (Si ou SiGe ou autre),
- former la deuxième couche dans laquelle le canal sera défini,
- rendre poreuse la première couche, la seconde couche pouvant être protégée par un oxyde qui pourra aussi servir d'oxyde de grille,
- former la grille et les espaceurs,
- former les zones dites de source et de drain.

La première couche peut alors être rendue isolante par oxydation.

La première couche peut être rendue poreuse, puis isolante, avant formation de la deuxième couche, dans laquelle le canal est ensuite réalisé.

La première couche peut être rendue poreuse après formation de la deuxième couche, dans laquelle le canal est ensuite réalisé.

Une étape préalable peut comporter la formation de fenêtres ou de zones dopées ou de tranchées dans la deuxième couche.

L'isolant de grille peut être réalisé en HfO₂, et la grille dans un empilement de TiN et d'une couche de silicium poly-cristallin.

Les espaceurs peuvent être réalisés en Si₃N₄, ou en un empilement de dioxyde de silicium et de nitrure de silicium Si₃N₄.

Avant formation des zones de drain et de source, une étape de gravure de la deuxième couche peut être réalisée, de part et d'autre de la zone de canal.

Avant formation des zones de drain et de source, une étape de gravure d'au moins une partie de l'épaisseur de la première couche, de part et d'autre de la partie de la première couche située sous la zone de canal, peut être réalisée.

Un procédé selon l'invention peut comporter, en outre, une gravure de toute l'épaisseur de la première couche, de part et d'autre de la partie de la première couche située sous la zone de canal

Une zone de la première couche, non gravée, peut subsister entre la zone gravée de la deuxième couche et des fenêtres ou des zones dopées dans la deuxième couche.

Les zones de source et de drain peuvent être formées par épitaxie dans les zones gravées de la deuxième et/ou de la première couche, d'un matériau de paramètre de maille différent du paramètre de maille du matériau sur lequel il est épitaxié et/ou de coefficient de dilatation thermique différent de celui sur lequel il est épitaxié.

Les zones poreuses peuvent être réalisées par transformation électrochimique, par exemple par électrolyse, notamment dans une solution contenant de l'acide fluorhydrique.

La deuxième couche peut être épitaxiée sur la première.

Elle peut être initialement en partie dopée N, puis une implantation peut être réalisée dans cette première couche, pour former un dopage N+.

Une étape de dopage de la zone de canal peut en outre être prévue.

### BRÈVE DESCRIPTION DES DESSINS

- La figure 1 représente un dispositif transistor connu,
- les figures 2a et 2b représentent des structures pour la réalisation d'un dispositif selon l'invention,
- les figures 3a - 10 représentent des étapes de procédés de réalisation d'un dispositif selon l'invention,
- la figure 11 représente un dispositif selon l'invention, en vue de dessus.

Sur ces différentes figures le rapport d'échelle entre les différents éléments n'est bien entendu pas égal à 1 et est susceptible de varier d'une figure à l'autre.

### EXPOSÉ DÉTAILLÉ DE MODES DE RÉALISATION PARTICULIERS

Deux exemples de dispositifs selon l'invention vont être donnés en liaison avec les figures 2a et 2b : la figure 2a illustre la préparation d'un substrat en matériau semi-conducteur 1, sur la totalité de sa surface, alors que la figure 2b illustre la formation, sur ce même substrat, de zones localisées 14, dopées N+ (un dopage P peut aussi être réalisé) qui ont pour vocation d'être ensuite rendues poreuses.

Ces deux versions de l'empilement technologique peuvent être obtenues par un enchaînement d'étapes telles que les suivantes.

On procède d'abord, sur le substrat 1, par exemple en silicium, à une épitaxie de silicium à dopage contrôlé (faiblement dopé N, à moins de 10¹⁷ at/cm³ afin de ne pas être rendue poreuse dans une étape ultérieure) pour la formation d'une première couche 10.

La partie 15 de la couche 10 peut être obtenue par implantation ou par épitaxie avec dopage in situ.

Dans le cas de la figure 2b, la partie de la couche 10, formée par les zones indexées 100, 102 et 14, est obtenue au cours de la même étape d'épitaxie que celle ayant permis la formation de la couche 10. Cette partie de la couche 10, comportant les zones 100, 102 et 14, est initialement faiblement dopée N.

La partie supérieure 15 de la couche 10 (figure 2a), ou une portion ou une zone 14 (figure 2b) latéralement limitée de cette couche 10, est ensuite implantée N+. Un dopage P est aussi réalisable.

Dans le cas de la figure 2b, la zone 14 est initialement faiblement dopée N de façon uniforme et donc, pour ne doper que cette zone, on utilise un masque d'implantation. Ce masque est supprimé avant la formation d'une deuxième couche 12, qui peut elle même être formée de plusieurs couches, la couche au contact de la couche ou zone 14 étant faiblement dopée N.

Il y a ensuite formation, par exemple par épitaxie, de cette deuxième couche 12, dans laquelle le canal du transistor sera réalisé.

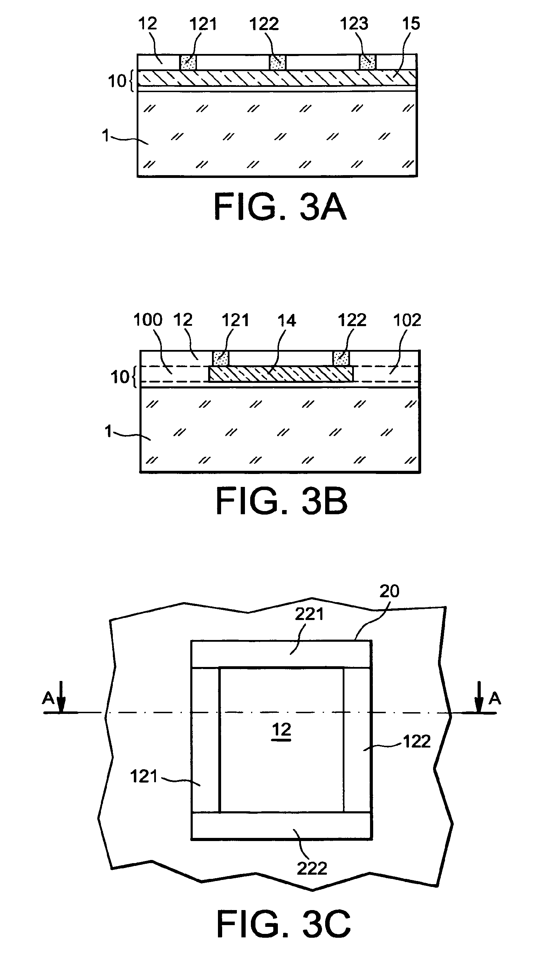

Une étape optionnelle peut consister à créer, dans cette couche 12, des zones dopées N+ (ou P) 121, 122, 123, comme illustré sur les figures 3a et 3b issues respectivement des structures des figures 2a et 2b. La formation de ces fenêtres dopées 121, 122, etc., traversant de part en part la couche 12 sur son épaisseur, et qui permettront de ne doper que les zones indexées 121, 122 ; 123...etc, est réalisée par implantation à l'aide d'un masque à implantation.

Ces zones ou fenêtres 121, 122, 123 permettront la formation ultérieure d'une isolation latérale, par oxydation préférentielle de ces mêmes zones ou fenêtres. Elles permettront aussi, dans le cas d'une zone ou couche 15 continue, de réaliser la porosification de cette zone 15, si cette porosification est réalisée après formation de la deuxième couche 12.

Les plaques subissent ensuite, éventuellement, un recuit de recristallisation et d'activation des dopants implantés: si l'implantation N+ (pour former la couche 15 ou la zone 14) engendre une amorphisation de la couche 14 implantée, la zone amorphisée est recuite à haute température. Un recuit à 1050°C, pendant quelques secondes, peut suffire pour que les atomes diffusent et que la zone amorphe recristallise. Une telle étape met en oeuvre des vitesses de montée et de descente en température très importantes, typiquement de l'ordre de 80K/s.

Les épaisseurs des couches 10, 12, 100 et 102 sont de préférence telles que, lors des étapes technologiques à haute température que le substrat peut éventuellement avoir à subir, avant l'étape de transformation électrochimique des zones 14, 15, ces couches ne perdent pas, ou peu, leur rôle de « couche d'arrêt » vis-à-vis de cette même transformation. Typiquement, les épaisseurs de ces couches sont supérieures à la longueur de diffusion de l'espèce considérée pendant les temps de recuit à haute température qu'elles peuvent être amenées à subir, longueur qui dépend elle - même de la température, de la durée des recuits, de l'espèce chimique qui diffuse et du matériau au sein duquel l'espèce diffuse. Ces couches ont par exemple une épaisseur comprise entre 10 nm et 30 nm ou 50 nm ou 100 nm. Par exemple, pour un recuit à 1050°C, dit de type SPIKE, cette longueur est de l'ordre de 8nm pour une couche 15 ou une zone 14 dopée à 10¹⁸atomes/cm³ et de l'ordre de 22nm pour une couche 15 ou une zone 14 dopée à 10²¹atomes/cm³.

D'autres procédés de réalisation des structures illustrées sur les figures 2a et 2b peuvent être proposés.

Ainsi, en variante, un traitement électrochimique, qui conduit à la transformation, en matériau semi-conducteur poreux, des zones 14, 15 situées dans la première couche 10, peut être mis en oeuvre avant la formation de la deuxième couche 12. Cette transformation en matériau poreux peut par exemple être réalisée par électrolyse dans une solution comprenant, au moins, de l'acide fluorhydrique. La formation de silicium poreux est par exemple expliquée dans l'ouvrage Properties of Porous Silicon (IEE, EMIS datareview series no 18, édité par L.Canham, 1997). La couche de Si poreux est ultérieurement oxydée, de préférence après toute étape d'épitaxie pour laquelle le silicium poreux est le support (on cherche à conserver le caractère cristallin en vue de l'épitaxie afin de donner lieu à un monocristal, c'est le cas du Si poreux). D'autres matériaux que le silicium peuvent être utilisés, par exemple SiGe ou Ge, avec une recette basse température pour ce dernier.

De préférence, la porosité de la couche transformée par un tel procédé est égale au rapport des volumes molaires du SiO₂ et du silicium, soit de l'ordre de 56%, si on souhaite que l'oxydation du silicium restant après transformation en Si poreux soit égal au volume du Si avant transformation en Si poreux. Si la porosité occupe moins de 56% (respectivement plus de 56%) du volume initial de silicium, l'oxyde formé sera dense (respectivement toujours poreux) et susceptible de solliciter mécaniquement les matériaux de son environnement en les mettant en compression. Pour une porosité supérieure (resp. inférieure) à 0,56, l'oxydation se traduit par une réduction (resp. une augmentation) du volume.

Le Si poreux étant un matériau cristallin (ce qui est également le cas si on utilise un autre semi-conducteur que le Si, par exemple SiGe ou Ge), il peut être utilisé comme substrat pour une croissance épitaxiale de silicium ou d'un autre matériau semi-conducteur (un alliage de silicium - germanium par exemple), en vue de réaliser la couche 12. La même remarque vaut pour un autre matériau tel que SiGe, ou Ge.

La croissance épitaxiale de cette couche 12 est réalisée à l'aide d'équipements tels que des équipements de CVD (Chemical Vapor Deposition) ou de MBE (Molecular Beam Epitaxy). De préférence, la température de croissance est inférieure à 700°C afin d'éviter une restructuration de la couche poreuse ; en outre, la vitesse de dépôt est relativement élevée (supérieure à 1 nm/mn) afin d'éviter le remplissage des pores ouverts des zones 14 ou 15. Cette épitaxie peut par exemple être effectuée à 650°C en utilisant du silane (SiH4) à une pression de 60 Torr.

En variante, le même traitement électrochimique (qui vient d'être expliqué ci-dessus) permettant de rendre poreuses les zones 14, 15, peut aussi être réalisé après la formation de la deuxième couche 12, en transformant la première couche 10 (devenue une couche enterrée) à partir des fenêtres implantées 121, 122, 123 illustrées sur les figure 3a et 3b. Un avantage est alors de disposer de zones préparées pour la formation de zones d'isolation latérale par le biais des zones 121, 122, 123,...etc qui pourront être oxydées préférentiellement dans la suite du procédé. Ces zones 121, 122, etc... sont transformées en zones poreuses en même temps que les zones 13, 15, ou avant, pour permettre de donner accès à ces dernières. La transformation en zones isolantes peut avoir lieu à partir du moment où ces zones ont joué leur rôle de support d'épitaxie.

Une vue de dessus de la structure illustrée sur la figure 3a peut être celle de la figure 3c, sur laquelle les zones 121, 122 définissent deux cotés d'un cadre qui entoure une portion du film 12. Deux autres côtés 221, 222, de même nature que les zones 121, 122, peuvent avoir été réalisés de la même manière que ces dernières. Le motif ainsi défini dans la couche 12 est alors entouré d'un caisson 20 délimité par les bords 121, 122, 221, 222 fortement dopés N+. Les figures 3a et 3b représentent alors des coupes selon l'axe AA de la figure 3c.

Pour les modes de réalisation, qui mettent en jeu la transformation électrochimique du silicium en silicium poreux dès la préparation du substrat dédié et avant formation de la couche 12, la température des étapes technologiques suivantes reste de préférence inférieure à environ 650°C, afin d'éviter le risque que le silicium poreux puisse se redensifier.

Dans le cas où le canal 2a (figure 1) est destiné à être dopé, notamment dopé N à plus de 10¹⁷ at/cm³, la transformation semi-conducteur→ semi-conducteur poreux se fait de préférence lors de l'étape de préparation du substrat spécifique (donc avant formation de la deuxième couche 12), pour éviter la perte de sélectivité vis-à-vis de la transformation électrochimique de la couche enterrée 12. Si le canal est dopé N+ ou P il est susceptible d'être transformé en Si poreux.

Le dopage du canal 2a peut alors être fait pendant l'étape d'épitaxie de la couche 12 elle-même, en n'altérant pas le caractère dense de la couche 12. L'épitaxie se faisant à partir d'une surface dans laquelle les pores débouchent, elle se fait dans des gammes de vitesses de croissance suffisamment élevées pour permettre d'occulter ces pores sans les remplir. La couche 12 est alors un monocristal respectant l'orientation cristalline du silicium de la couche 10. La dose du dopage peut être réglée par le rapport des mélanges gazeux introduits dans la chambre d'épitaxie. Ce dopage peut aussi être réalisé après épitaxie par une étape standard d'implantation.

On a donc obtenu un substrat comportant une première couche poreuse, continue ou non, et une deuxième couche 12, dans laquelle le canal du transistor est réalisé, mais aussi au moins en partie des cavités pour former la source et le drain.

On peut aussi, à ce stade, ne pas avoir encore rendu poreuse la première couche. Dans ce cas, on a donc d'abord réalisé une première couche 10, non encore poreuse et isolante, puis une deuxième couche 12.

Le Si ou le SiGe ou le Ge, qu'ils soient poreux ou denses, sont cristallins. Ils peuvent donc être le support d'une croissance épitaxiale, chacun avec ses conditions d'épitaxie propre : la vitesse d'épitaxie sur une surface poreuse, ou surface à laquelle débouchent les pores, est choisie suffisamment élevée pour occulter les pores sans les remplir.

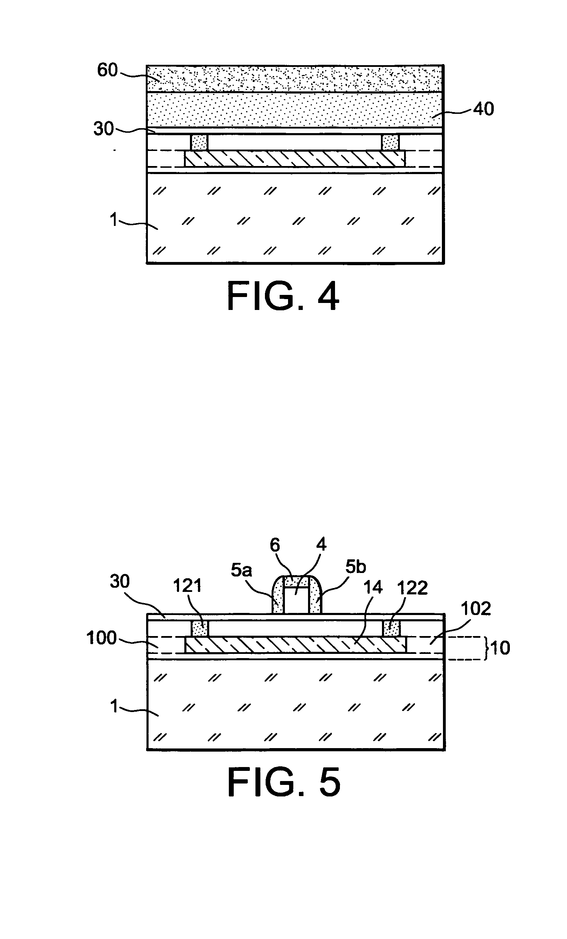

A partir d'un tel substrat, un empilement de grille 4 ainsi que des espaceurs 5a, 5b vont pouvoir être réalisés (figure 5). Ces éléments sont mis en oeuvre différemment, selon que la couche enterrée 14, 15 est déjà poreuse ou non.

Si cette zone 14 est encore dense (pas encore porosifiée), on met de préférence en oeuvre des matériaux qui résistent vis-à-vis de l'étape électrochimique qui permettra ultérieurement de transformer le matériau semi-conducteur dense en semi-conducteur poreux. Cette étape électrochimique pouvant mettre en jeu une solution chimique contenant, entre autre, de l'acide fluorhydrique (FH), les matériaux susceptibles d'être attaqués par cette solution seront de préférence évités ou protégés. Par exemple, le diélectrique de grille 3 (figure 1) pourra être formé à partir d'une couche 30 en matériau diélectrique à haute permittivité, tel que le dioxyde d'hafnium (HfO₂), ou l'alumine Al₂O₃ ou l'oxyde de zirconium ZrO₂, ou en un empilement de ces matériaux, plutôt qu'en SiO₂. Le matériau en contact avec le HF résistera à cet acide (ce sera par exemple HfO₂).

Dans le cas de l'utilisation d'HfO₂ pour le diélectrique de grille 3, la grille 4 sera de préférence obtenue à partir d'un empilement d'une couche de TiN et d'une couche de silicium poly-cristallin (figure 4). Si la couche 14 est déjà poreuse, l'oxyde de grille peut être en SiO₂ et la grille peut n'être constituée que de silicium polycristallin.

Les espaceurs 5a, 5b peuvent être formés en nitrure Si₃N₄ et, dans ce cas, le sommet de la grille 4 est protégé par une couche dans laquelle la gravure des espaceurs s'arrêtera. Cette couche peut elle même être une couche de nitrure et est indexée 60 sur la figure 4, qui illustre l'empilement technologique construit avant la gravure de la grille. La figure 5 illustre la topologie du composant après la gravure de la grille 4 et la gravure des espaceurs 5a, 5b. La couche ou zone 40 est la couche de grille (Si polycristallin ou TiN + Si-polycristallin). La couche 60 représente la couche d'arrêt ou masque dur qui subsiste au sommet de la grille sur la figure 5 après gravure des espaceurs : elle protège la grille d'une étape ultérieure d'attaque chimique.

Le bilan thermique total que l'architecture aura vu avant l'étape de transformation électrochimique des zones 14 et 121 - 123 (si ces dernières existent) est pris en compte lors du dimensionnement des couches d'arrêt 10 et 12.

Si la couche ou la zone 14 ou 15 est déjà poreuse on met alors en oeuvre de préférence des procédés basse température et les matériaux associés, en évitant de préférence la formation d'oxyde thermique SiO₂ en tant que diélectrique de grille. On peut, par exemple, déposer du HfO₂ (à environ 650°C) sur quelques nanomètres d'épaisseur pour former la couche 30.

Comme spécifié précédemment, l'utilisation de HfO₂ comme diélectrique de grille 3 permet de réaliser un empilement de grille 3 d'une couche TiN et d'une couche en silicium poly-cristallin.

Les espaceurs 5a, 5b peuvent être formés d'un empilement de dioxyde de silicium déposé à basse température et d'un nitrure de silicium SiN déposé aussi à basse température. La couche d'oxyde 30 sert alors de couche d'arrêt à la gravure des espaceurs et il n'y a pas besoin de la couche 60 illustrée sur la figure 4. La figure 4 illustre l'architecture qui peut être mise en oeuvre avant la gravure de la grille alors que la figure 5 illustre la configuration obtenue après les gravures de la grille 4 et des espaceurs 5a, 5b, l'oxyde piédestal 30 étant conservé.

Les zones 121, 122, 123 étant déjà porosifiées, les conditions de dépôt de la couche d'oxyde 3 et du diélectrique 30 de grille sont de préférence sélectionnées afin d'occulter les pores débouchant de ces zones 121 - 123 sans pour autant les remplir. Cette condition permet de ré-accéder à la zone enterrée 14. Si ces conditions ne sont pas satisfaites on peut dégager ces zones d'accès par une gravure localisée au niveau de ces zones d'accès 121 - 123 à la couche enterrée 14.

En ce qui concerne une éventuelle implantation dans la couche 12, celle-ci peut être réalisée, dans le cas où la couche 14 est déjà poreuse, à travers l'oxyde déposé, et ce avant et/ou après la formation des espaceurs 5a, 5b eux même (avant le dépôt nitrure). Cette implantation de la couche 12 est destinée à former les zones dites d'extension des source et drain, le canal étant masqué par la grille.

Si la couche 14 n'est pas encore poreuse les conditions d'implantation tiendront compte du budget thermique à venir, afin que la couche 12 ne soit pas rendue poreuse, puisqu'elle sera le lieu du transport électronique lorsque le transistor sera fonctionnel. En d'autres termes, si implantation il y a, les profils d'implantation sont choisis tels que, à l'étape de la transformation électrochimique semi-conducteur dense → semi-conducteur poreux, il subsiste entre la couche 14 et la couche 12, dont les couches superficielles viennent d'être dopées, une zone dont le dopage est de type N et la concentration en dopant est inférieure à 10¹⁷atomes/cm³. A cette fin, on épaissit la couche 12 de départ pour que, au final, cette condition soit vérifiée.

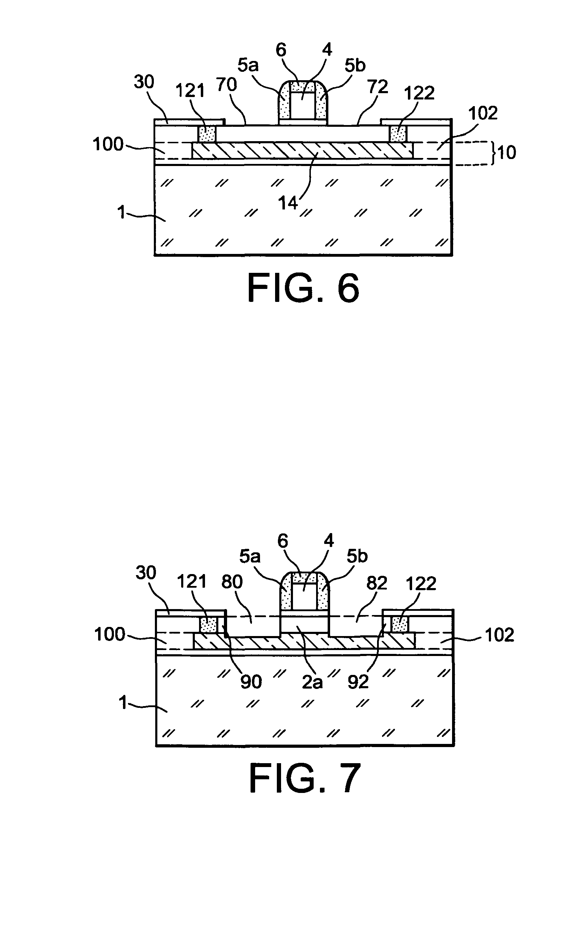

Un enchaînement d'étapes de masquage et de retrait du diélectrique permet ensuite d'accéder à la surface de la couche de silicium faiblement dopée 12 en préservant le diélectrique 30 à l'aplomb des zones 121 - 123 (si elles existent). On peut ainsi définir des zones latérales 70 et 72 de part et d'autre des espaceurs, comme illustré sur la figure 6, sur lesquelles le masque de gravure a été supprimé.

Dans le cas d'espaceurs 5a, 5b de type oxyde/nitrure, la gravure de l'oxyde dans les zones 70 et 72 est réalisée de manière à ne pas endommager l'oxyde 6 au sommet de la grille 4: un masquage de la grille 4 est alors réalisé, alors que la couche 6 illustrée sur la figure 5a sert de masque naturel.

Une étape de gravure anisotrope est alors réalisée, la couche 30 de diélectrique de grille servant de masque naturel dans les endroit où elle subsiste.

Cette gravure est arrêtée dans la couche 15 ou 14, comme l'illustre la figure 7 sur laquelle sont représentées les cavités 80 et 82 ainsi formées de part et d'autre de la grille, entre les zones indexées 121 et 123.

Cette illustration donne la topologie du dispositif obtenu à partir de la figure 6, et donc de la figure 5.

Une épaisseur 1 de matériau semi-conducteur 90, 92 non gravé, située entre la cavité et les éventuelles zones 121, 123, peut être dimensionnée pour assurer une certaine rigidité élastique au cadre de silicium qui va ainsi entourer les cavités 80 et 82. La géométrie rectangulaire des cavités 80 et 82, visible sur la figure 7, n'est qu'indicative : les flans verticaux de ces cavités peuvent en réalité présenter une certaine inclinaison et/ou une certaine courbure.

Une reprise d'épitaxie peut alors être mise en oeuvre dans les cavités 80 et 82, par exemple une épitaxie d'un alliage 100, 102 de silicium et de germanium sur le silicium peut être réalisée : cette étape conduit à la mise en compression de cet alliage épitaxié, dont le paramètre de maille naturel est plus grand que celui du silicium ou du matériau semi-conducteur 14, 15 sur lequel il croît. Cet état de contrainte du matériau épitaxié dans les cavités 80 et 82 va se répercuter sur l'état de contrainte de la zone 2a (canal) de la couche 10 qui subsiste sous la grille 4. Ainsi, dans le cas d'une épitaxie de SiGe, la zone en question est mise en compression lorsque l'équilibre mécanique global de la structure est établi.

Dans le cas où on veut solliciter le canal en tension, on fait croître un alliage dont le paramètre de maille est plus faible que celui du matériau utilisé comme support d'épitaxie (14, 15). Ainsi, si 14 et 15 sont en SiGe, on utilise du silicium dans les cavités 80 et 82. Sinon, il y a toujours la solution d'utiliser un matériau dont le coefficient de dilatation thermique est plus élevé que celui de la couche qui a la plus grande rigidité (le substrat) et qui va donc imposer ses déplacements au reste des couches et donc solliciter le matériau en question en traction lorsqu'il est porté de sa température de dépôt T_{dep} à sa température ambiante (T_{dep}>T_{amb}).

Si les zones 14 et 15 (support à l'épitaxie) sont en Si, on peut utiliser un alliage en SiGeC, dont les teneurs en carbone sont telles que le paramètre de maille du SiGeC sont plus faibles que celui du silicium.

Le matériau de remplissage des cavités 80 et 82 peut aussi être un matériau de coefficient de dilatation différent de celui du silicium : lors du retour à température ambiante à partir de la température à laquelle le matériau en question est déposé, ce matériau ne se rétracte pas de la même façon que le substrat et il est donc contraint. Il sera comprimé (resp. mis en tension) si son coefficient de dilatation est plus faible (resp. plus élevé) que celui du substrat silicium : le canal 2a du transistor sera donc lui même mis en compression (resp. en tension).

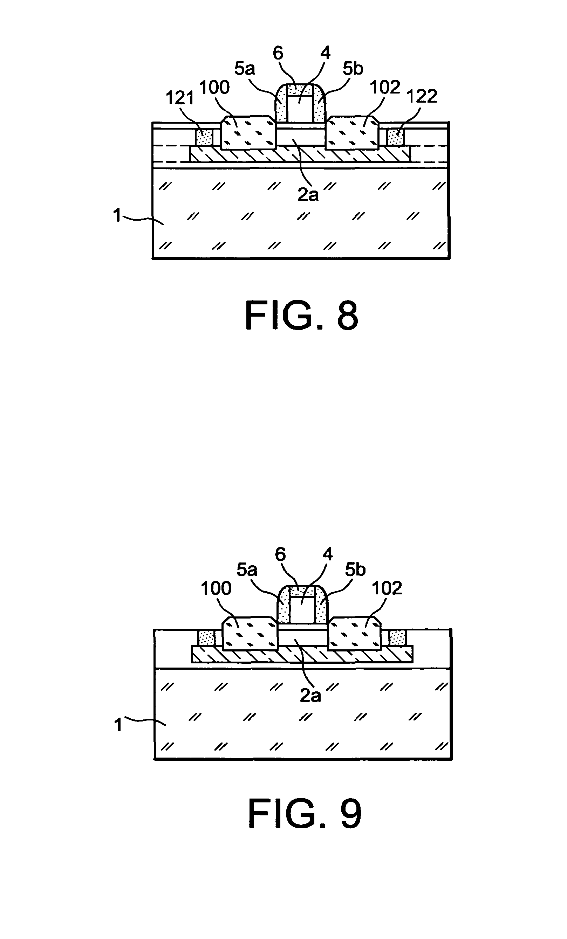

La figure 8 illustre la topologie obtenue à partir de l'état présenté sur la figure 7, en tenant compte d'une étape d'épitaxie et d'une étape de retrait du diélectrique de grille 30 à l'aplomb des zones d'accès 121 - 123.

Les cavités 80 et 82 peuvent aussi déboucher dans la couche 10 ou même dans le substrat 1. Dans ce cas, la couche 14 ou 15 est rompue en différentes zones non connexes. La fonction finale de ces zones étant d'isoler le dispositif du substrat, elles sont alors rendues poreuses (si elle ne le sont pas encore) puis oxydées.

Cette oxydation conduit aussi à une oxydation du fond et des flans des cavités 80, 82, qui peuvent être débarrassées de cet oxyde par une étape d'attaque chimique à base d'acide fluorhydrique.

La reprise d'épitaxie est alors possible dans ces cavités nettoyées.

Si les zones dopées N+ (121 - 123 et 14, 15) sont déjà poreuses, les paramètres d'épitaxie sont de préférence choisis pour obstruer les pores débouchant au fond des cavités, sans pour autant remplir ces pores.

Dans la même hypothèse des zones dopées N+ (121 - 123 et 14, 15) déjà poreuses, le cadre en silicium dense, défini par les portions 90, 92 sur la figure 7, permet d'entourer les zones épitaxiées dans un cadre plus rigide que le cadre simplement constitué de silicium poreux. La contrainte vers le canal du transistor est alors transmise plus efficacement. Plus ces zones 90, 92 auront une largeur 1 importante, plus le transfert de contrainte vers le canal 2a sera efficace.

A partir de l'état illustré par la figure 8, si la couche ou zone 14, 15 n'est pas encore poreuse, elle peut être rendue poreuse selon la méthode électrochimique décrite dans l'ouvrage « Properties of Porous Silicon » déjà cité ci-dessus. Si les espaceurs 5a, 5b sont un bicouche SiO₂/Si₃N₄, un masquage de la grille évitera la consommation de l'oxyde lors de cette étape. Pour cette raison, des espaceurs 5a, 5b en nitrure, avec protection du sommet de la grille par un nitrure, sont préférables.

L'invention permet donc d'obtenir un dispositif à canal contraint entouré d'un caisson de silicium poreux, quel que soit le moment auquel la transformation des zones 121 - 123 et 14, 15 en matériau semi-conducteur poreux ait été réalisée.

Une étape finale d'oxydation permet d'oxyder préférentiellement le silicium poreux. La structure finale est celle présentée sur la figure 9 où la zone 10 est formée d'un isolant électrique poreux (SiO₂) et entoure un dispositif de type transistor MOS contraint. Cette zone résulte de l'oxydation des zones 121 - 123 et 14, 15 précédemment rendue poreuses.

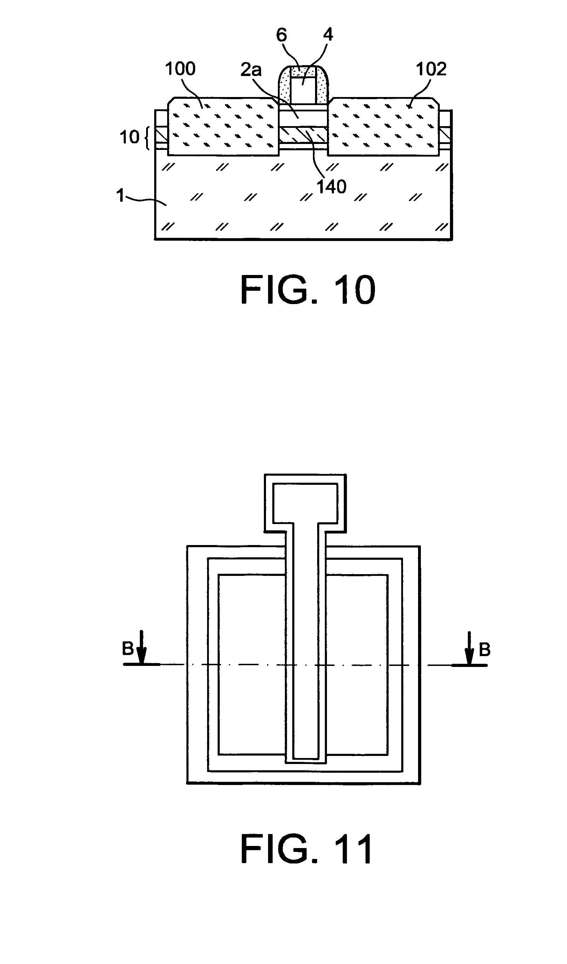

Si les cavités 80 et 82 ont débouché dans la couche 10, voire dans le substrat 1, la structure finale en coupe correspond à celle présentée sur la figure 10.

Dans ce cas, le canal 2a est bien contraint et isolé du substrat par la zone 140, les zones de drain et de source 100, 102 reposant sur le substrat.

Dans le cas d'une source et d'un drain tous deux en SiGe, le dispositif est particulièrement intéressant pour un composant de type PMOS, puisque le canal est en compression et que, donc, la mobilité des trous est accrue par rapport à un cas non contraint.

Dans le cas d'une source et d'un drain en un matériau dont le coefficient de dilatation est plus grand que celui du substrat (Si), cette architecture est particulièrement intéressante pour un composant de type NMOS, puisque le canal en tension augmente la mobilité des électrons.

Le dispositif peut alors être achevé et une vue schématique de dessus du dispositif ainsi construit est illustrée sur la figure 11, la figure 10 pouvant représenter un coupe de cette vue de dessus prise selon le plan de coupe BB défini sur la figure 11.

Si des accès 121 - 123 n'ont pas été formés comme illustré les figures 2a et 2b, un accès à la couche enterrée 14, 15 peut être obtenu par une ouverture, dans la couche 12, de tranchée dite STI pour « Shallow Trench Isolation ». Cette tranchée devra déboucher dans la couche enterrée 14, 15 pour permettre sa transformation en matériau semi-conducteur poreux et/ou son oxydation. La tranchée peut ensuite être comblée par un isolant électrique (SiO₂). En vue de dessus, la topologie finale sera alors semblable à celle présentée sur la figure 11.

Le matériau rendu poreux au cours du procédé a une rigidité mécanique dégradée par rapport au matériau dense. Le cadre (figure 11) formé par les zones 90 et 92 permet d'assurer un meilleur transfert des contraintes des source et drain vers le canal (celui - ci est dense). A la fin, le matériau isolant n'est plus poreux.

Quel que soit le mode de réalisation envisagé parmi ceux décrits ci-dessus, un dispositif et un procédé selon l'invention permettent d'obtenir une contrainte qui s'exerce sur toute l'épaisseur du canal 2a, ce qui homogénéise l'état de contrainte du canal.

## Revendications

1. Dispositif semi-conducteur de type transistor à canal contraint et isolé du substrat, comportant :
- un substrat (1),
- un transistor ayant une zone de canal, une zone de source (100) et une zone de drain (102), ces zones de drain et de source exerçant une contrainte mécanique sur le canal,
- une grille (4), séparée de la zone de canal par un isolant de grille (3).
- une couche isolante (14, 15, 121, 122, 123) en oxyde d'un matériau semi-conducteur poreux donné, la couche isolante s'étendant sous le transistor et comportant de parois latérales (121, 122, 123) de part et d'autre de la zone de source (100) et de drain (102) du transistor,
- la zone de canal (2a) étant disposée sur la couche isolante, les zones de drain (100) et de source (102) étant disposées sur une zone de la couche isolante et comprises entre les parois latérales en oxyde du matériau semi-conducteur poreux donné.

2. Dispositif selon la revendication 1, la couche isolante étant en oxyde de silicium.

3. Dispositif selon la revendication 2, les zones de source et de drain étant en SiGe.

4. Dispositif selon la revendication 1, la couche isolante étant en oxyde à base de SiGe.

5. Dispositif selon la revendication 4, les zones de source et de drain étant en Silicium.

6. Dispositif selon la revendication 1, la couche isolante étant en oxyde à base de SiₓGe₁₋ₓ (0<x<1).

7. Dispositif selon la revendication 6, les zones de source et de drain étant en Si_{y}Ge_{1-y} (0<y<1).

8. Dispositif selon l'une des revendications 1 à 7, comportant des zones (90, 92) données d'une première couche dans lequel le canal est réalisé et situées entre la source et les parois latérales poreuses ainsi qu'entre le drain et les parois latérales poreuses, les zones données (90, 92) permettant d'assurer un maintien mécanique des zones de source, de drain et de canal.

9. Dispositif selon l'une des revendications précédentes, le matériau constitutif des zones de drain et de source étant de paramètre de maille et/ou de coefficient de dilatation thermique différent du paramètre de maille et/ou du coefficient de dilatation thermique du matériau semi-conducteur donné.

10. Dispositif selon l'une des revendications précédentes, comprenant en outre des espaceurs de part et d'autre de la grille, les espaceurs (5a, 5b) étant en Si₃N₄ ou comportant un empilement de SiO₂ et de Si₃N₄.

11. Dispositif selon l'une des revendications précédentes, la zone de canal étant implantée N+.

12. Procédé de formation, sur un substrat (1), d'un transistor à canal contraint et isolé du substrat, comportant :
- formation, sur ledit substrat (1), d'une couche (14, 15, 121, 122, 123), dite première couche,
- formation d'une zone de canal sur la première couche, dans une couche (12) en matériau semi-conducteur, dite deuxième couche,
- formation d'un isolant de grille (3) et d'une grille (4) et d'espaceurs de part et d'autre de la grille,
- formation de zones de drain (100) et de source (102), de part et d'autre du canal (2a), la zone de canal étant contrainte par ces zones de drain et de source,
le procédé étant **caractérisé en ce que** la première couche est rendue poreuse, puis isolante, après formation de la deuxième couche (12) par :
- porosification à travers des zones dopées (121, 122, 123) ou des tranchées formées dans la deuxième couche,
- oxydation à travers les zones dopées ou les tranchées.

13. Procédé selon la revendication 12, dans lequel, après formation d'un isolant de grille (3), d'une grille (4) et d'espaceurs de part et d'autre de la grille, on réalise dans cet ordre ou un ordre inverse :
- l'étape de formation de zones de drain (100) et de source (102), de part et d'autre du canal (2a),
- l'étape de transformation du matériau de la première couche rendu poreux en un matériau isolant poreux, par oxydation dudit matériau poreux à travers les zones dopées (121, 122, 123) ou des tranchées formées préalablement dans la deuxième couche.

14. Procédé selon l'une des revendications 12 ou 13, dans lequel les zones dopées sont transformées en zones poreuses en même temps ou avant ladite porosification de la première couche.

15. Procédé selon l'une des revendications 12 à 14, les espaceurs étant réalisés en un empilement de dioxyde de silicium et de nitrure de silicium SiN.

16. Procédé selon l'une des revendications 12 à 14, comportant, avant formation des zones de drain et de source, une étape de gravure de la deuxième couche, de part et d'autre de la zone de canal.

17. Procédé selon la revendication 16, comportant en outre, avant formation des zones de drain et de source, une gravure d'au moins une partie de l'épaisseur de la première couche, de part et d'autre de la partie de la première couche située sous la zone de canal.

18. Procédé selon la revendication 17, comportant en outre, une gravure de toute l'épaisseur de la première couche, de part et d'autre de la partie de la première couche située sous la zone de canal.

19. Procédé selon l'une des revendications 13 à 18, une zone (90, 92) de la première couche, non gravée, subsistant entre la zone gravée de la deuxième couche et des fenêtres ou des zones dopées (121, 122, 123) dans la deuxième couche.

20. Procédé selon l'une des revendications 13 à 19, les zones de source et de drain étant formées par épitaxie dans les zones gravées de la deuxième et/ou de la première couche, d'un matériau de paramètre de maille différent du paramètre de maille du matériau sur lequel il est épitaxié et/ou de coefficient de dilatation thermique différent de celui sur lequel il est épitaxié.

21. Procédé selon l'une des revendications 13 à 20, la porosification étant réalisée par transformation électrochimique.

22. Procédé selon la revendication 21, dans lequel la transformation électrochimique est une électrolyse, les zones poreuses étant formées dans une solution contenant de l'acide fluorhydrique.

23. Procédé selon l'une des revendications 13 à 22, la deuxième couche étant épitaxiée sur la première.

24. Procédé selon l'une des revendications 13 à 23, la première couche étant initialement en partie dopée N, puis une implantation étant réalisée dans cette première couche, pour former un dopage N+.

25. Procédé selon l'une des revendications 13 à 24, comportant en outre une étape de dopage de la zone de canal.

## Patentansprüche

1. Halbleitervorrichtung vom Typ Transistor mit verspanntem und vom Substrat isolierten Kanal, umfassend:
- ein Substrat (1)
- einen Transistor mit einer Kanalzone, einer Sourcezone (100) und einer Drainzone (102), wobei diese Drain- und Sourcezonen eine mechanische Spannung auf den Kanal ausüben,
- ein Gitter (4), das von der Kanalzone durch einen Gitterisolator (3) separiert ist
- eine isolierende Schicht (14, 15, 121, 122, 123) aus einem gegebenen porösen Halbleitermaterialoxid, wobei sich die isolierende Schicht unter dem Transistor erstreckt und laterale Wände (121, 122, 123) auf beiden Seiten der Sourcezone (100) und der Drainzone (102) des Transistors umfasst,
- wobei die Kanalzone (2a) auf der isolierenden Schicht angeordnet ist, wobei die Drainzone (100) und die Sourcezone (102) auf einer Zone der isolierenden Schicht angeordnet und zwischen den lateralen Wänden aus dem gegebenen porösen Halbleitermaterialoxid enthalten sind.

2. Vorrichtung nach Anspruch 1, wobei die isolierende Schicht aus Siliziumoxid ist.

3. Vorrichtung nach Anspruch 2, wobei die Source- und die Drainzone aus SiGe sind.

4. Vorrichtung nach Anspruch 1, wobei die isolierende Schicht aus einem Oxid auf Basis von SiGe ist.

5. Vorrichtung nach Anspruch 4, wobei die Source- und die Drainzone aus Silizium sind.

6. Vorrichtung nach Anspruch 1, wobei die isolierende Schicht aus einem Oxid auf Basis von SiₓGe₁₋ₓ (0<x<1) ist.

7. Vorrichtung nach Anspruch 6, wobei die Source- und die Drainzone aus SiyGe₁₋y (0<y<1) sind.

8. Vorrichtung nach einem der Ansprüche 1 bis 7, umfassend gegebene Zonen (90, 92) einer ersten Schicht, in der der Kanal realisiert ist, die zwischen der Source und den porösen lateralen Wänden sowie zwischen der Drain und den porösen lateralen Wänden angeordnet sind, wobei die gegebenen Zonen (90, 92) es ermöglichen, einen mechanischen Halt der Source-, der Drain-, und der Kanalzone zu gewährleisten.

9. Vorrichtung nach einem der vorhergehenden Ansprüche, wobei das Material, aus dem die Drain- und die Sourcezone gebildet sind, einen Gitterparameter und/oder einen thermischen Ausdehnungskoeffizienten aufweist, der verschieden ist vom Gitterparameter und/oder thermischen Ausdehnungskoeffizienten des gegebenen Halbleitermaterials.

10. Vorrichtung nach einem der vorhergehenden Ansprüche, ferner umfassend Abstandshalter auf beiden Seiten des Gitters, wobei die Abstandshalter (5a, 5b) aus Si₃N₄ sind oder einen Stapel von SiO₂ und Si₃N₄ umfassen.

11. Vorrichtung nach einem der vorhergehenden Ansprüche, wobei die Kanalzone N+-implantiert ist.

12. Verfahren zur Bildung eines Transistors mit verspanntem und vom Substrat isolierten Kanal auf einem Substrat (1), umfassend:
- das Bilden einer Schicht (14,15, 121, 122, 123), genannt erste Schicht, auf dem Substrat (1),
- das Bilden einer Kanalzone auf der ersten Schicht in einer Schicht (12) aus Halbleitermaterial, genannt zweite Schicht,
- das Bilden eines Gitterisolators (3) und eines Gitters (4) und von Abstandshaltern auf beiden Seiten des Gitters,
- das Bilden einer Drainzonen (100) und einer Sourcezone (102) auf beiden Seiten des Kanals (2a), wobei die Kanalzone durch diese Drainzone und Sourcezone verspannt wird,
wobei das Verfahren **dadurch gekennzeichnet ist, dass** die erste Schicht nach dem Bilden der zweiten Schicht (12) durch folgende Schritte porös und dann isolierend gemacht wird:
- Porosierung durch Dotierungszonen (121, 122, 123) oder Gräben, die in der zweiten Schicht gebildet sind
- Oxidation durch die Dotierungszonen oder die Gräben.

13. Verfahren nach Anspruch 12, bei dem man nach dem Bilden eines Gitterisolators (3), eines Gitters (4) und von Abstandshaltern auf beiden Seiten des Gitters folgende Schritte in dieser Reihenfolge oder einer inversen Reihenfolge durchführt:
- den Schritt des Bildens einer Drainzone (100) und einer Sourcezone (102) auf beiden Seiten des Kanals (2a),
- den Schritt des Transformierens des porös gemachten Materials der ersten Schicht in ein poröses isolierendes Material durch Oxidation des porösen Materials durch die Dotierungszonen (121, 122, 123) oder durch Gräben, die zuvor in der zweiten Schicht gebildet wurden.

14. Verfahren nach einem der Ansprüche 12 oder 13, bei dem die Dotierungszonen gleichzeitig mit oder vor der Porosierung der ersten Schicht in poröse Zonen transformiert werden.

15. Verfahren nach einem der Ansprüche 12 bis 14, wobei die Abstandshalter mit einem Stapel von Siliziumdioxid und Siliziumnitrid SiN realisiert werden.

16. Verfahren nach einem der Ansprüche 12 bis 14, umfassend, vor dem Bilden der Drainzone und der Sourcezone einen Schritt des Gravierens der zweiten Schicht auf beiden Seiten der Kanalzone.

17. Verfahren nach Anspruch 16, ferner umfassend, vor dem Bilden der Drainzone und der Sourcezone, ein Gravieren wenigstens eines Teils der Dicke der ersten Schicht auf beiden Seiten des Teils der ersten Schicht, der unter der Kanalzone gelegen ist.

18. Verfahren nach Anspruch 17, ferner umfassend ein Gravieren der gesamten Dicke der ersten Schicht auf beiden Seiten des Teils der ersten Schicht, der unter der Kanalzone gelegen ist.

19. Verfahren nach einem der Ansprüche 13 bis 18, wobei eine nicht gravierte Zone (90, 92) der ersten Schicht zwischen der gravierten Zone der zweiten Schicht und Fenstern oder Dotierungszonen (121, 122, 123) in der zweiten Schicht verbleibt.

20. Verfahren nach einem der Ansprüche 13 bis 19, wobei die Sourcezone und die Drainzone durch Epitaxie in den gravierten Zonen der zweiten und/oder der ersten Schicht aus einem Material mit einem Gitterparameter gebildet werden, der verschieden ist vom Gitterparameter des Materials, auf dem epitaktisch aufgewachsen wurde, und/oder mit einem thermischen Ausdehnungskoeffizienten, der verschieden ist von jenem, auf dem epitaktisch aufgewachsen wurde.

21. Verfahren nach einem der Ansprüche 13 bis 20, wobei die Porosierung durch elektrochemische Transformation realisiert wird.

22. Verfahren nach Anspruch 21, bei dem die elektrochemische Transformation eine Elektrolyse ist, wobei die porösen Zonen in einer Lösung gebildet werden, die Fluorwasserstoffsäure enthält.

23. Verfahren nach einem der Ansprüche 13 bis 22, wobei die zweite Schicht epitaktisch auf der ersten aufgewachsen wird.

24. Verfahren nach einem der Ansprüche 13 bis 23, wobei die erste Schicht anfänglich teilweise N-dotiert ist, und dann eine Implantierung in dieser ersten Schicht realisiert wird, um eine N+-Dotierung zu bilden.

25. Verfahren nach einem der Ansprüche 13 bis 24, ferner umfassend einen Schritt des Dotierens der Kanalzone.

## Claims

1. Semi-conductor device of transistor with strained channel insulated from the substrate, comprising:
- a substrate (1),
- a transistor with a channel zone, a source zone (100), and a drain zone (102), said source and drain zones applying a mechanical strain over said channel zone,
- a gate (4), separated from said channel by a gate insulator (3),
- an insulating layer (14, 15, 121, 122, 123) made of an oxide of a given porous semi-conductor, the insulating layer extending under the transistor and comprising sidewalls (121, 122, 123) formed on either side of the source zone (100) and the drain zone (102) of the transistor,
- the channel zone (2a) being arranged on said insulating layer, the drain and source zones being formed on a region of said insulating layer and arranged between the sidewalls made of the oxide of the given porous semi-conductor.

2. Device according to claim 1, said insulating layer being made of silicon oxide.

3. Device according to claim 2, said source zone and the drain zone being made of SiGe.

4. Device according to claim 1, said insulating layer being made of an SiGe-based oxide.

5. Device according to claim 4, said source zone and said drain zone being made of silicon.

6. Device according to claim 1, said insulating layer being made of an SiₓGe₁₋ₓ-based oxide (0<x<1).

7. Device according to claim 6, said source zone and said drain zone being made of Si_{y}Ge_{1-y} (0<y<1).

8. Device according to any of the claims 1 to 7, comprising given zones (90, 92) of a first layer in which the cannel is formed, the given zones being situated between the source and the porous sidewalls and between the drain and the porous sidewalls, the given zones (90, 92) enabling mechanical support of said source, drain and channel zones.

9. Device according to any of the preceding claims, the material constituting drain and source zones having a lattice parameter and/or coefficient of thermal expansion different from the lattice parameter and/or the coefficient of thermal expansion of the given semi-conductor material.

10. Device according to any of the preceding claims, further comprising spacers on either side of the gate, the spacers being made of Si₃N₄ or comprising a stack of SiO₂ and Si₃N₄.

11. Device according to any of the preceding claims, said channel zone being N+ implanted.

12. A Method for the formation on a substrate of a strained channel transistor isolated from said substrate, comprising:
- formation of a layer (14, 15, 121, 122, 123), called first layer, on said substrate (1),
- formation of a channel zone on said first layer, in a layer (12) made of a semiconducting material called second layer,
- formation of a gate insulator, of a gate and of spacers on each side of said gate,
- formation of drain (100) and source zones (102), on each side of said channel (2a), said channel zone being strained by said drain and source zones,
the method being **characterized in that** said first layer is made porous, then insulating, after formation of said second layer (12), by:
- Porosification through doped zones (121, 122, 123) or trenches formed in the second layer,
- Oxidation through the doped zones or the trenches.

13. Method according to claim 12, wherein after forming of a date insulator, a gate and of spacers on each side of said gate, one conducts forms in this order or in the reverse order:
- the step of formation of drain (100) and source zones (102), on each side of said channel (2a),
- the step of transforming the material rendered porous of the first layer into a insulating porous material by oxidation of said porous material through the doped zones (121, ,122, 123) or of the trenches formed previously in the second layer.

14. Method according to any of the claims 12 or 13, wherein the doped zones are transformed in porous zones at the same time or before said porosification of the first layer.

15. Method according to any of the claims 12 to 14, said spacers consisting of a stack of silicon dioxide and silicon nitride SiN.

16. Method according to any of the claims 14 to 16, including, before said drain and source zones are formed, an etching step of said second layer, on each side of said channel zone.

17. Method according to claim 16, further including, before forming said drain and said source zones, etching of at least a part of a thickness of said first layer on each side of said part of said first layer located under said channel zone.

18. Method according to claim 17, further including etching of the entire thickness of said first layer on each side of the part of said first layer located under said channel zone.

19. Method according to claim 18, a non-etched zone of said first layer remaining between said etched zone of said second layer and doped windows or zones in said second layer.

20. Method according to any of the claims 13 to 19, said source and drain zones being formed by epitaxy in etched zones of said second and/or first layer, of a material with a lattice parameter different from a lattice parameter of the material on which it is epitaxied and/or a coefficient of thermal expansion different from that of the material on which it is epitaxied.

21. Method according to any of the claims 13 to 20, said porous zones being made by electro-chemical transformation.

22. Method according to claim 21, said electro-chemical transformation being an electrolysis, said porous zones being formed by electrolysis in a solution containing hydrofluoric acid.

23. Method according to any of the claims 13 to 22, said second layer being epitaxied on said first layer.

24. Method according to any of the claims 13 to 23, said first layer initially being partly N doped, then an implantation being done in said first layer to form N+ doping.

25. Method according to any of the claims 13 to 24, further including a step to dope said channel zone.
